# EUROPEAN PATENT APPLICATION

(11) **EP 4 761 559 A1**
(43) Date of publication of application: **17.06.2026**
(21) Application number: 25222976.0
(22) Date of filing: 12.12.2025
(51) Int. Cl.: H10W 42/00, H10W 76/40, H05K 7/10, H10W 90/10, H10W 70/60

(54) **INTEGRATED CIRCUIT PACKAGE WITH COMPRESSION STRUCTURE FOR ATTACHING COMPONENTS TO A PACKAGE SUBSTRATE**

(30) Priority: 12.12.2024 US 202463733278 P; 08.04.2025 US 202519173387
(71) Applicant: Avago Technologies International Sales Pte. Limited, Singapore 768923 (SG)
(72) Inventor: Woody, Christopher Paul, Fort Collins, 80526 (US)
(74) Representative: Dilg, Haeusler, Schindelmann Patentanwaltsgesellschaft mbH

(57) **Abstract**

Compact mechanisms for attaching co-packaged devices to integrated circuit (IC) packages. An example integrated circuit includes a substrate having an outer periphery; a circuit die disposed on the substrate and contained within the outer periphery; a stiffener structure that is disposed on the substrate, contained within the outer periphery, and including a threaded opening; a compression structure secured to the stiffener structure via the threaded opening; and a co-packaged device (CPD) disposed on the substrate such that a first surface portion of the CPD contacts the compression structure and such that a second surface portion of the CPD contacts the substrate.

## Description

### BACKGROUND

The present disclosure relates, in general, to integrated circuit (IC) packaging techniques. More specifically, the present disclosure relates to mechanisms for attaching co-packaged devices to IC packages.

### BRIEF DESCRIPTION OF THE DRAWINGS

FIG. 1 is a perspective illustration that shows example components of an example integrated circuit, in accordance with some aspects of the disclosure.
FIG. 2 is a perspective illustration that shows additional example components of the integrated circuit of FIG. 1, in accordance with some aspects of the disclosure.
FIG. 3 is a perspective illustration that shows further example components of the integrated circuit of FIG. 1, in accordance with some aspects of the disclosure.
FIG. 4 is a perspective illustration that shows cross section of the integrated circuit of FIG. 1, in accordance with some aspects of the disclosure.
FIG 5 is a perspective illustration that shows example components of another example integrated circuit, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits, programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

Integrated circuit packages (e.g., packages containing one or more application-specific integrated circuits (ASICs)) that are housed on various types of printed circuit boards (PCBs) continue to see integration of elements (e.g., interconnects, memory, networking, optics, etc.) that historically have been distributed across the PCB. This approach, which is sometimes referred to as "co-packaging", can be used to reduce cost and to improve performance in certain applications. In some previous approaches, co-packaging can be achieved by soldering a co-packaged device (CPD) to a package substrate in a similar manner as a main IC is attached to the package substrate. However, these approaches can present issues with the complexity of the package manufacturing process and the serviceability of the package in the field.

In some other previous approaches, the CPD may be attached to the package substrate without solder via compression of some sort of interposer between the CPD and the package substrate. While these approaches can allow for some added flexibility in manufacturing with respect to how and when the CPD is attached to the package substrate and some improvements with respect to servicing the CPD in the field, these approaches still require a mechanism capable of maintaining adequate compressive forces between the CPD and the package substrate over the course of the service life of the CPD. Additionally, these approaches also may involve structures that occupy space and/or PCB assembly resources (e.g., PCB through holes, PCB bolster plates, etc.) supplemental to and outside of the integrated circuit package. The mechanisms as detailed below with respect to the example integrated circuit 100 and the example integrated circuit 200 can be used to overcome these and other drawbacks associated with some previous approaches.

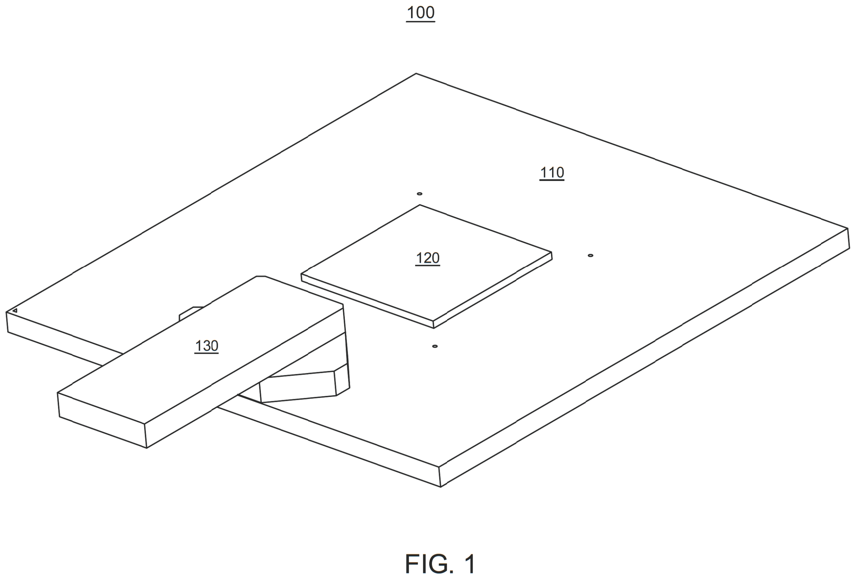

Referring to FIG. 1, a perspective illustration of example components of an example integrated circuit 100 is shown, in accordance with some aspects of the disclosure. The integrated circuit 100 can be implemented as any of a variety of different types of integrated circuits. For example, the integrated circuit 100 can be an ASIC used in various applications (e.g., networking applications, processing applications, communications, etc.). As shown, the integrated circuit 100 can include a substrate 110, a circuit die 120, and a co-packaged device (CPD) 130. The substrate 110 can generally be a substrate that at least partially defines a package for the integrated circuit 100. For example, the substrate 110 can include various types of conductive terminals that can be used to connect the integrated circuit 100 to a host printed circuit board (PCB) in any of a variety of types of electronic devices and systems. Similarly, the circuit die 120 can be implemented as any of a variety of types of circuit dies used for various applications. The circuit die 120 can, in some examples, be considered a "main" circuit die of the integrated circuit 100 that is included within the same package as the co-packaged device 130.

The co-packaged device 130 can be implemented in various suitable manners using various suitable components. For example, the co-packaged device 130 can be implemented using various components that may be integrated within the same package as the circuit die 120 ("co-packaged" with the circuit die 120). The co-packaged components can include various types of optical components, memory components, networking components, additional circuit dies (e.g., in a 2.5D configuration with one or more interposers, in a 3D stack, etc.), and/or other suitable types of components. For example, the co-packaged device 130 can be implemented as an electrical launch device that can transfer electrical signals from the integrated circuit 100 to the host PCB (e.g., serializer/deserializer (SerDes) connections, ball grid array (BGA) pads, radio frequency (RF) launch structures, etc.). The co-packaged device 130 can also be implemented as an optical launch device that allows the integrated circuit 100 to transfer data to the host PCB using light (e.g., co-packaged optics, silicon photonics, vertical-cavity surface-emitting-laser (VCSEL), etc.). The co-packaged device 130 can also be implemented as a cooling device or other type of thermal device that provides thermal management for the integrated circuit 100 (e.g., a heat sink structure, etc.). The integrated circuit 100 can also include more than one co-packaged device.

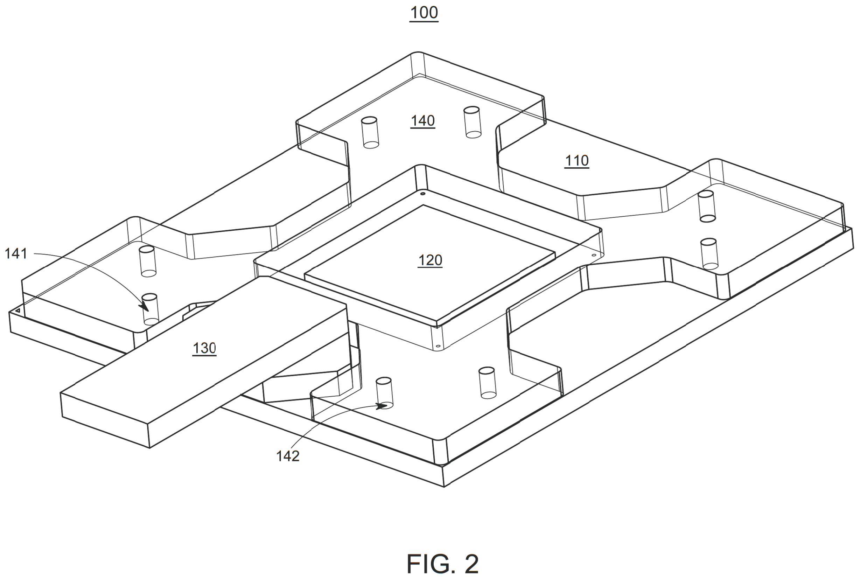

Referring to FIG. 2, a perspective illustration of additional example components of the integrated circuit 100 is shown, in accordance with some aspects of the disclosure. As shown, the integrated circuit 100 can also include a stiffener structure 140 that is disposed on the substrate 110. The stiffener structure 140 can generally provide support for the compression structure 150 as will be detailed further below. The stiffener structure 140 can be secured to the substrate 110 using an adhesive material, in some examples. The adhesive material can be any of a variety of suitable types of adhesive materials and can vary depending on the intended application. Further, the stiffener structure 140 can consist essentially of stainless steel material in order to provide added support for compressive forces. This design choice can provide advantages in terms of withstanding compressive forces when compared to some alternative materials including copper.

Further, as shown in FIG. 2, the stiffener structure 140 can include an opening 141 and an opening 142. The opening 141 and the opening 142 can generally serve as anchor points for the compression structure 150 as will be detailed further below. Advantageously, the opening 141 and the opening 142 can be efficiently produced via drilling and tapping, which is an inexpensive machining process. As such, the opening 141 and the opening 142 can each be threaded openings. The geometry and the dimensional characteristics of the threading used in the opening 141 and the opening 142 can vary depending on the application. In some examples, to provide added structural support, the diameter of each of the opening 141 and the opening 142 can be between 2 millimeters and 4 millimeters. However, the sizing and number of openings included in the stiffener structure 140 can vary depending on factors including the compressive force requirements for a given application, the available space on the stiffener structure 140, the material(s) used to implement the stiffener structure 140, the density of co-packaged device placement(s), for example, among other potential factors. While the stiffener structure 140 is shown to include eight openings in the example illustrated in FIG. 2, the stiffener structure 140 can any suitable quantity of openings.

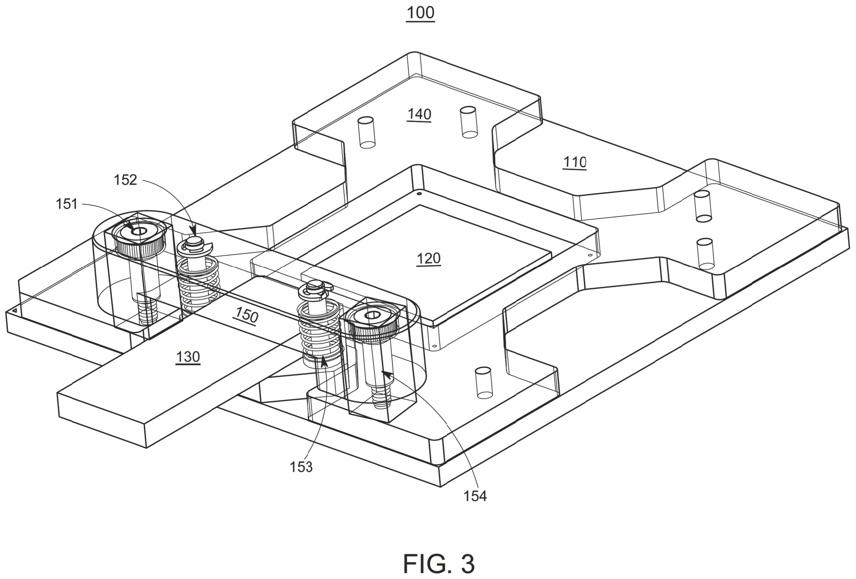

Referring to FIG. 3, a perspective illustration of further example components of the integrated circuit 100 is shown, in accordance with some aspects of the disclosure. As shown, the integrated circuit 100 can also include a compression structure 150, as mentioned above. In the example shown in FIG. 3, the compression structure 150 can be secured to the stiffener structure 140 via the opening 141 and the opening 142 as shown in FIG. 2. Specifically, the compression structure 150 can be secured to the stiffener structure 140 via the opening 141 and the opening 142 using a fastener 151 and a fastener 154. The fastener 151 and the fastener 154 can be implemented using any of a variety of suitable types of fasteners. As shown in FIG. 3, a first surface portion of the co-packaged device 130 can contact the compression structure 150 and a second surface portion of the co-packaged device 130 can contact the substrate 110. As a result, the co-packaged device 130 can generally be disposed between the substrate 110 and the compression structure 150. Accordingly, the compression structure 150 can apply a compressive force to the co-packaged device 130 that allows for compressive attachment of the co-packaged device 130 to the substrate 110 without requiring solder. The compression structure 150 is also shown to include a spring plunger 152 and a spring plunger 153, as will be detailed further below.

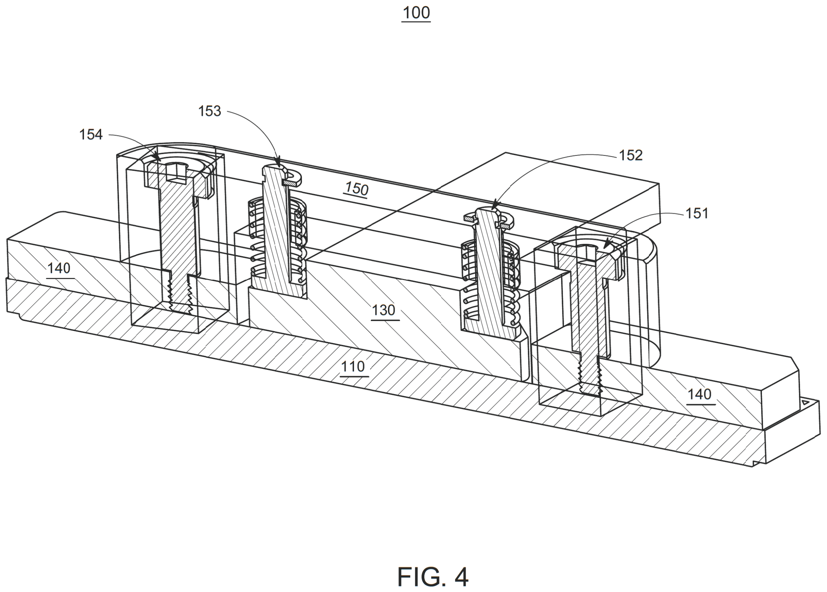

Referring to FIG. 4, a perspective illustration of a cross section of the integrated circuit 100 is shown, in accordance with some aspects of the disclosure. The cross section is generally taken through the compression structure 150 and the co-packaged device 130. As shown in FIG. 4, the spring plunger 152 and a spring plunger 153 both contact a top surface portion of the co-packaged device 130 to apply a compressive force to the co-packaged device 130 that holds the co-packaged device 130 in place. In some examples, the compression structure 150 can include only one spring plunger, or can also include more than two spring plungers. As an alternative, the compression structure 150 can also include an elastic material (e.g., an elastic pad) that contacts the first surface portion of the co-packaged device 130, among other possible implementations of the compression structure 150. Additionally, the main body of the compression structure 150 can include or can consist essentially of a metal material. The metal material can be any of a variety of suitable metals (e.g., stainless steel, copper, titanium, etc.) such that the compression structure 150 can generally be a metallic structure.

The first surface portion and the second surface portion of the co-packaged device 130 that contact the compression structure 150 and the substrate 110, respectively, can vary depending on the implementation of the co-packaged device 130. As an example, the first surface portion and the second surface portion of the co-packaged device 130 can be on the same surface of the co-packaged device 130, or can be on different surfaces of the co-packaged device 130. Moreover, there can be intervening layers (e.g., the elastic pad referenced above, etc.) included on the substrate 110, the co-packaged device 130, and/or the compression structure 150 such that the contact between the first surface portion of the co-packaged device 130 and the compression structure 150 and the substrate 110 and/or the contact between the second surface portion of the co-packaged device 130 and the substrate 110 is not necessarily be "direct" contact.

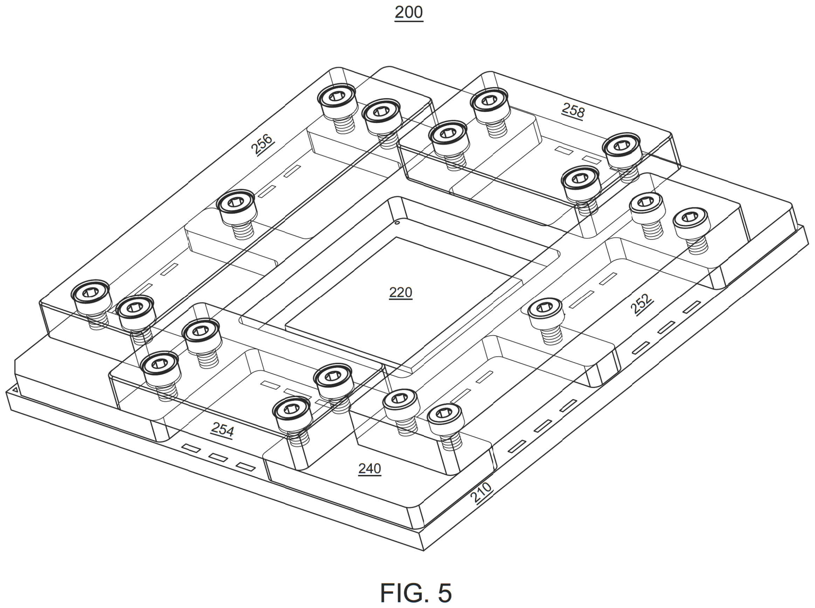

Referring to FIG. 5, a perspective illustration of example components of another example integrated circuit 200 is shown, in accordance with some aspects of the disclosure. The integrated circuit 200 can generally be similar to the integrated circuit 100. However, the integrated circuit 200 provides an example of a more complete integrated circuit assembly that includes four separate compression structures similar to the compression structure 150 detailed above with respect to the integrated circuit 100. In particular, as shown in FIG. 5, the integrated circuit 200 can include a substrate 210 (e.g., similar to the substrate 110), a circuit die 220 (e.g., similar to the circuit die 120), and a stiffener structure 240 (e.g., similar to the stiffener structure 140). Additionally, the integrated circuit 200 is shown to include a compression structure 252, a compression structure 254, a compression structure 256, and a compression structure 258. As shown, the compression structure 252, the compression structure 254, the compression structure 256, and the compression structure 258 can each be secured to the stiffener structure 240 via fasteners (e.g., similar to the fastener 152 and the fastener 153).

While the co-packaged devices are not expressly illustrated in FIG. 5, it can be seen that the integrated circuit 200 can include up to six separate co-packaged devices. The compression structure 254 and the compression structure 258 can each apply a compressive force to one co-packaged device, and the compression structure 252 and the compression structure 258 can each apply a compressive force to two co-packaged devices. For example, looking at the compression structure 252, five separate fasteners are shown to secure the compression structure 252 to the stiffener structure 240. The middle fastener that is shown by itself in this example can be disposed between two separate co-packaged devices. Accordingly, using the designs detailed herein, any number of co-packaged devices can be attached in a single integrated circuit. The number of co-packaged devices included in the integrated circuit can again vary based on factors including the compressive force requirements for a given application, the space that is available on the stiffener structure 140, the material(s) that are used to implement the stiffener structure 140, the density of co-packaged device placement(s), for example, among other potential factors.

The integrated circuit 100 (and the integrated circuit 200) can provide a more compact mechanism for attaching co-packaged devices when compared to some previous approaches. As shown in FIG. 2 and FIG. 3, the stiffener structure 140 (as well as the opening 141 and the opening 142, and the fastener 152 and the fastener 153) can be contained within an outer periphery of the substrate 110 such that the stiffener structure 140 anchors the compression structure 150 within the outer periphery of the substrate 110 (e.g., inside of the integrated circuit 100 module). As such, the design of the stiffener structure 140 and the compression structure 150 can provide a stable and reliable anchor structure even for small area compressive loads in excess of 50 pounds of force (lbf). The term "outer periphery" of the substrate 110 generally refers to the outer edges of the substrate 110 (from the perspective shown in FIGS. 1-3) and a vertical plane that extends above and below the outer edges of the substrate 110. The term "contained within the outer periphery" of the substrate 110 generally means that no portion of the associated structure that is contained within the outer periphery of the substrate 110 extends past these outer edges of the substrate 110 or extends through the vertical plane that extends above and below the outer edges of the substrate 110. For example, as shown in FIG. 2, the stiffener structure 140 is contained within the outer periphery of the substrate 110.

Additionally, the design of the stiffener structure 140 and the compression structure 150 can allow for context neutrality in the sense that it allows the integrated circuit 100 to be connected to a host PCB in any suitable manner (e.g., using a ball grid array (BGA) mechanism, using a lang grid array (LGA) mechanism, etc.). In some alternative approaches where the anchor points lie outside of the periphery of the package substrate, this same context neutrality is not possible. Further, the various forces at play during attachment of co-packaged devices (e.g., the upward force exerted by the co-packaged device, downward force exerted by the anchoring compression mechanisms, etc.) can create a delicate balance in terms of the compressive attachment of the co-packaged devices. The specific design of the stiffener structure 140 and the compression structure 150 can allow the fasteners (e.g., the fastener 152 and the fastener 153) to be placed particularly close to the co-packaged device 130, which can help balance these forces and reduce the potential of these forces leading to undesirable effects.

## Claims

1. An integrated circuit, comprising:
a substrate comprising an outer periphery;
a circuit die disposed on the substrate and contained within the outer periphery;
a stiffener structure disposed on the substrate and contained within the outer periphery, the stiffener structure comprising a first threaded opening;
a compression structure secured to the stiffener structure via the first threaded opening; and
a first co-packaged device disposed on the substrate such that a first surface portion of the first co-packaged device contacts the compression structure and such that a second surface portion of the first co-packaged device contacts the substrate.

2. The integrated circuit of claim 1, wherein
the stiffener structure is secured to the substrate via an adhesive material.

3. The integrated circuit of claim 1 or 2, wherein
the stiffener structure consists essentially of a stainless steel material.

4. The integrated circuit of any one of the preceding claims, wherein
the first co-packaged device comprises an optical launch device or an electrical launch device.

5. The integrated circuit of any one of the preceding claims, wherein
a diameter of the first threaded opening is between 2 millimeters and 4 millimeters.

6. The integrated circuit of any one of the preceding claims, wherein
the compression structure comprises a spring plunger that contacts the first surface portion of the first co-packaged device.

7. The integrated circuit of claim 6, wherein
the compression structure comprises a second spring plunger that contacts the first surface portion of the first co-packaged device.

8. The integrated circuit of any one of the preceding claims, wherein
the compression structure comprises an elastic material that contacts the first surface portion of the first co-packaged device.

9. The integrated circuit of any one of the preceding claims, wherein
the compression structure comprises a metal material.

10. The integrated circuit of any one of the preceding claims, wherein
the stiffener structure comprises a second threaded opening and
the compression structure is secured to the stiffener structure via the second threaded opening.

11. The integrated circuit of claim 10, wherein
the first co-packaged device is not connected to the substrate via solder.

12. An integrated circuit of any one of the preceding claims 10 or 11, wherein
the stiffener structure comprises a third threaded opening;
the compression structure is secured to the stiffener structure via the third threaded opening; and
the integrated circuit comprises a second co-packaged device disposed on the substrate such that a first surface portion of the second co-packaged device contacts the compression structure and such that a second surface portion of the second co-packaged device contacts the substrate.

13. The integrated circuit of claim 12, wherein
the second threaded opening is disposed between the first co-packaged device and the second co-packaged device.
